# EUROPEAN PATENT APPLICATION

(11) **EP 1 655 839 A2**
(43) Date of publication of application: **10.05.2006**
(21) Application number: 05256899.5
(22) Date of filing: 08.11.2005
(51) Int. Cl.: H03K 17/96

(54) **Spa capacitive switch**

(30) Priority: 08.11.2004 US 984571
(71) Applicant: Dimension One Spas, Vista, California 92081 (US)
(72) Inventor: Hutchings, Brent Mark, Ramona California 92065 (US)
(74) Representative: Loveless, Ian Mark

(57) **Abstract**

A spa system controlled by capacitive sensing. In one implementation, a spa control system includes a capacitive sensor to receive input from a spa user. The capacitive sensor is operable to sense a change in capacitance due to an object being in proximity with the capacitive sensor. The system includes a control unit coupled to the capacitive sensor to control at least one spa function.

## Description

### TECHNICAL FIELD

The present disclosure relates to control switches for spas.

### BACKGROUND

The sophisticated safety requirements and operational features of today's spas, pools and hot tubs allow design engineers to add more peripheral features that enhance the user's experience.

Spa controls can be in various locations in a spa. In one example, the controls are on the outside of the spa. In that example, the spa user has to go outside of the spa to change a switch for water flow, water heating, water level within the spa, and/or other spa accessories. For instance, controls are typically located in the front of the spa unit. Various switch configurations have been implemented to allow the user to perform these actions from the seating area of the spa. However, implementing these switch configurations may mean that the spa shell is to be penetrated, which may result in potential leakage points at the mechanical connection or at an internal actuator within the spa enclosure.

Although much of the peripheral "on/off" switching can be done from a central spa control user interface, there can be other operations that would benefit from distributing the switch operations around the spa at locations that are spatially relevant to the activity. For example, if a user sits in a certain seat near a control switch, the jet pump for that seat can be energized and then de-energized without the user leaving the seat. For such localized switching, some system designs may have mechanical switches or magnetic switching. Mechanical switch implementations may use a mechanical connection with watertight sealing through the spa enclosure. In a magnetic switch implementation, a user may press a magnet-filled button against the spa enclosure and a resulting magnetic field can be detected via a mechanical reed switch. One such magnetic switch implementation is U.S. Patent No. 6,775,863 B2 to Hutchings.

In another example, the controls and knobs of the control system may be subject to the harsh environment of the spa, such as the heat of the water and the corrosive environment of exposure to the water in the spa, as well as from potential leakage from the seals around the controls and knobs. In particular, mechanical contact switches can be susceptible to dirt, corrosion, seal leaks, wear, and contamination. In addition, if the control switch is located below the waterline, replacement of the control components may be time-consuming and labor-intensive, with expensive draining and refilling of the spa. Other costs of mechanical switches may include watertight seals, molded buttons, and permanent magnets.

### SUMMARY

The present disclosure describes a system that, in one implementation, involves a spa control system with a capacitive sensor configured to receive input from a spa user. The capacitive sensor is operable to sense a change in capacitance due to an object being in proximity with the capacitive sensor. The system includes a control unit coupled with the capacitive sensor to control at least one function.

The present disclosure describes a method to control one or more functions of a spa. The method involves receiving user input using capacitive sensing to adjust at least one spa function. The capacitive sensing includes detecting when an object is in proximity of an oscillator. The oscillator is operable to vibrate when an object is in proximity of the oscillator, and a capacitance of the oscillator is a function of the proximity of the object with the oscillator. The capacitive sensing also includes detecting a vibration of the oscillator when the object is in proximity of the oscillator, and changing a status of a control device in response to detecting the vibration. The method also includes adjusting the spa function based on the changing status of the control device.

Another implementation involves an apparatus to control one or more spa operations, in which the apparatus includes electrical components operable to detect an input from a user by sensing a change in capacitance in response to an object being in proximity with a capacitive sensor, and convert the detected input into a signal to change a state of a control device. The control device is coupled to one or more spa controls. The apparatus also includes adjusting the one or more spa controls in response to the change in state of the control device.

The systems and techniques described here may provide one or more of the following advantages. For example, by not having to penetrate the shell of the spa, the number of available locations that a control switch can be placed increases. The capacitive switch may not require physical wires, contacts, and plug connections that are currently used in conventional mechanical switches, including reed switches, at the spa seating section. As a result the capacitive switch is less susceptible to dirt, corrosion, wear, and/or contamination. The capacitive switch can use fewer components when compared to a conventional mechanical switch system, which may, for example, contain molded rubber buttons and permanent electromagnets. As a result the capacitive switches can reduce costs associated with an amount of labor for manufacturing and installation. Also, because capacitive switches may be located below the waterline of the spa, replacement of the capacitive switches may be less costly than mechanical switches. For example, replacement of the mechanical switch may be a costly and time-consuming process that includes draining the spa, allowing the spa to dry, replacing the mechanical switch, creating and verifying a watertight seal for the switch, and then refilling the spa with water. However, replacement of a capacitive switch below the waterline can be conducted behind the spa shell, without draining the spa or without creating a watertight seal. Because watertight seals are not required for the capacitive switch, there can be a reduction in spa repair and maintenance.

Details of one or more implementations are set forth in the accompanying drawings and the description below. Other features and advantages will be apparent from the description and drawings, and from the claims.

### DRAWING DESCRIPTIONS

FIG. 1A illustrates a diagram of a top view of a spa.
FIG. 1B illustrates a diagram of a seating area view of the spa shown in FIG. 1A.
FIGS. 2A-2E illustrate various locations of the switch in the spa.
FIG. 3 illustrates a diagram of components of the capacitive switch.
FIG. 4 shows a diagram of spa function control.
Like reference symbols in the various drawings indicate like members.

### DETAILED DESCRIPTION

The following detailed description makes reference to the accompanying drawings. Other implementations of the present invention are possible and modifications may be made to the implementations without departing from the spirit and scope of the invention.
Therefore, the following detailed description is not meant to limit the invention. Rather the scope of the invention is defined by the appended claims.

Moreover, for convenience in the ensuing description, some explanations of terms are provided herein. However, the explanations contained herein are intended to be exemplary only. They are not intended to limit the terms as they are described or referred to throughout the specification. Rather these explanations are meant to include any additional aspects and/or examples of the terms as described and claimed herein and/or as used by one of skill in the art.

The following describes various techniques and systems relating to a switch for a spa that is based on capacitive energy principles. The capacitive switch can detect a presence of a spa user's body (e.g., the proximity of a hand or foot) and use that proximity to control at least one function of the spa. The proximity of the spa user can be detected across a non-conductive gap either above or below the waterline of the spa. The non-conductive gap may be filled with an insulator, such as air, plastic, or glass. In one implementation, the non-conductive gap may be between the spa user's hand and a capacitive sensor on the back (i.e., non-water) side of a spa shell. In another implementation, the non-conductive gap may include part of the shell of the spa, in addition to another layer of plastic or glass. A spa control system can support multiple switches at multiple locations throughout the spa.

In one implementation, a "sensing target" can be demarcated with a decorative design, a printing, a label, a molding, a pattern, or a texture in the spa shell enclosure. The "sensing target" can refer to an area of the spa shell enclosure that is to be touched to initiate the switching. The capacitive switches here may also be referred to as "touch" switches, "proximity switches", or "capacitive sensors".

In another implementation, the capacitive switches can be suitable for both contact and non-contact sensing. The contact sensing refers to sensing action associated with touching the sensing target, and non-contact sensing refers to sensing action associated with not touching the sensing target, but in close proximity to the sensing target. The capacitive switches can be used above and/or below the waterline of the spa.

In one aspect, the capacitive switch may include a capacitive detector component at the sensing target and electronics associated with the capacitive detector component. In another aspect, the capacitive sensor may include multiple components at multiple locations, including the capacitive detector component and electronics associated with the detection.

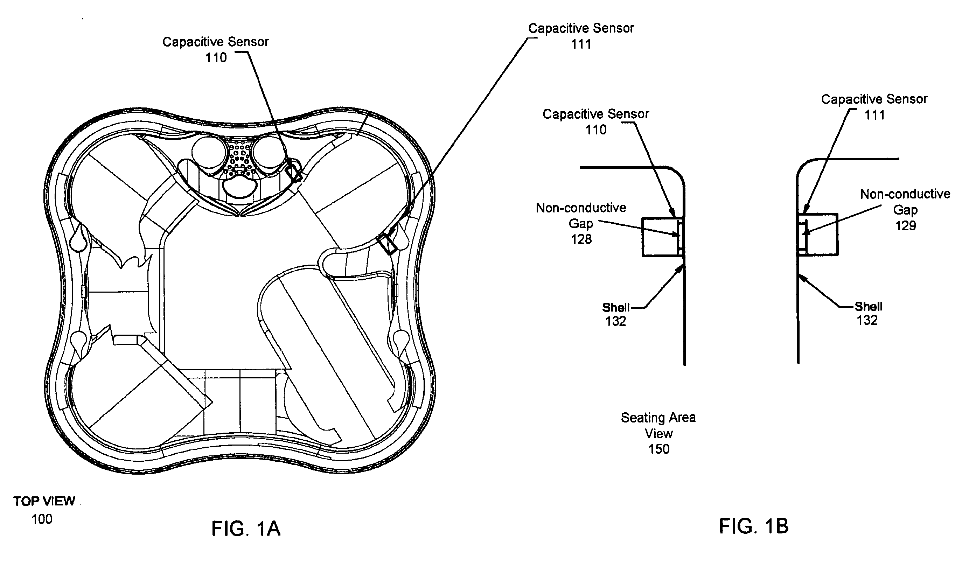

FIG. 1A shows a diagram of a top view of a spa 100 with multiple capacitive sensors 110, 111 at a seating area of the spa. A spa user in the seating area can touch the sensing target area of the spa to control spa functions. The spa functions may include controlling a flow of the water, a heating of the water, a direction of water flow, and accessories of the spa, such as a volume of a sound system. In one implementation, a spa user may "tap" a sensing area a number of consecutive times to control the flow of the water out of the water jets around the seating area. For example, the spa user may tap a sensing area once to turn on water jets for a low level of water flow, tap the sensing area a second time (i.e., tap the sensing area a total of two times) to increase the water jets to a medium level of water flow, tap the sensing area a third time (i.e., tap the sensing area a total of three times) to increase the flow out of the water jets to a high level of water flow, and tap the sensing area a fourth time (i.e., tap the sensing area a total of four times) to turn off the water jets and cease the corresponding water flow.

FIG. 1B shows a side view of the seating area 150 (not to scale). The capacitor sensors 110, 111 can be installed behind a wall of the spa shell 132. In one implementation, the walls of the spa shell 132 are not punctured or have an opening to when the capacitive sensors 110, 111 are installed, therefore a seal is not used during the install. The electrical components of the capacitive sensors 110, 111 can be located behind the wall of the spa shell 132. The capacitive sensors 110, 111 may have a non-conductive gap 128, 129 filled with, for example, air, plastic, or glass. The distance of the gap may depend on a size, a shape, and/or one or more physical characteristics of the object being sensed.

In one implementation, electrical components associated with the capacitive sensors may be positioned directly behind the non-conductive gap. In another implementation, electrical components associated with the capacitive sensor 110 may be coupled to a central spa control system, in which multiple sensors can be coupled to control spa functions. The central spa control system may be located behind the wall of the spa shell, and isolated from the corrosive environment of being near the water in the spa.

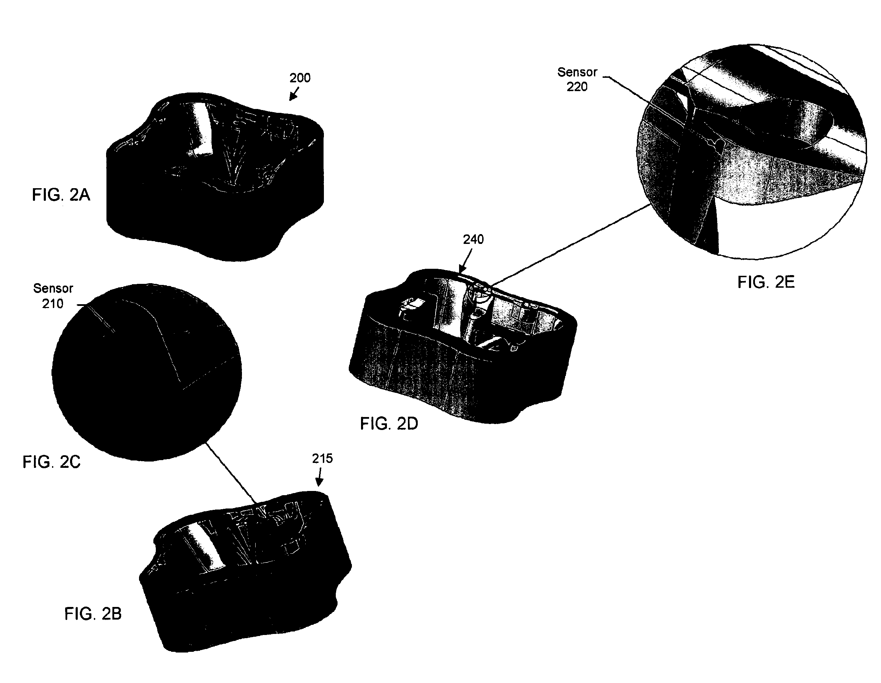

FIGS. 2A-2E illustrate various locations of the switch in the spa. For the user's convenience, the sensor locations may be situated close to a seating area of the user. For spa 200 in Fig. 2A, the capacitive sensor 210 in Fig. 2C is positioned around seating area 215. In Fig 2E, the capacitive sensor 220 is positioned around seating area 240 in Fig. 2D.

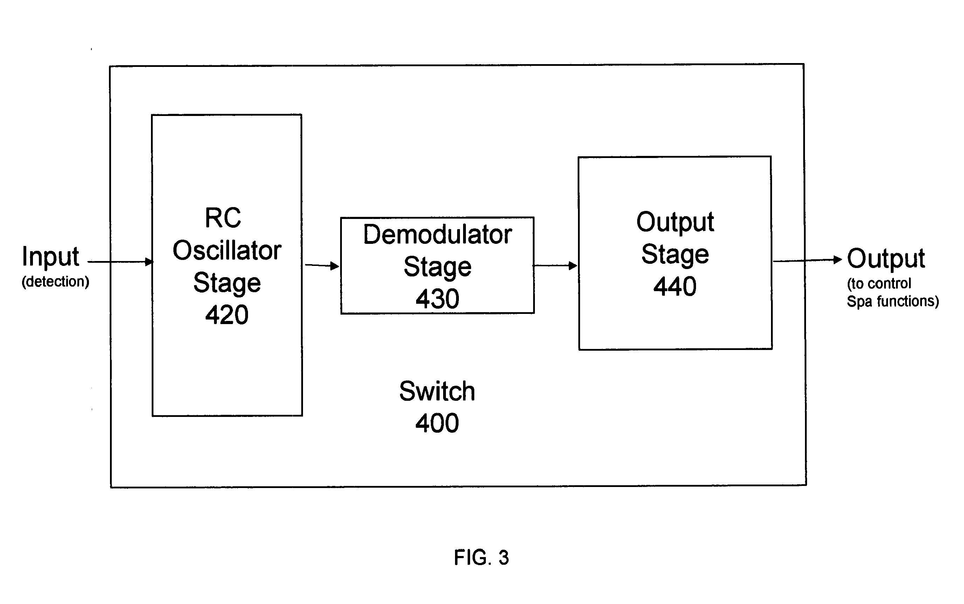

FIG. 3 illustrates a diagram of components of the capacitive switch 400. The switch 400 can include an input section to an resistor-capacitor (RC) oscillator stage 420 to detect a body part. The output of the RC oscillator state 420 is coupled to a demodulator stage 430, followed by an output stage 440. When metals or non-metals are in proximity of sensing target, a change in capacitance can cause the RC oscillator to oscillate or vibrate. When the oscillator vibrates, the demodulator stage 430 changes from one state to another state, like a switch turning "on" and "off". As a result, the output stage may also change states correspondingly, like a switch. The switch function at the output stage 440 can be in a "normally-open" state or a "normally-closed" state. In one implementation, the output stage 440 may be a open-collector transistor output stage and may have an open-collector transistor output (e.g., a NPN-type output or PNP-type output).

The capacitance of the RC oscillator can be a function of the distance of the object (e.g., a hand) from a sensing target located on the spa. The objects can have a dielectric coefficient that can depend on a type of material or conductivity of the object. Objects with a large relative dielectric coefficient and surface (e.g., a human body) may be easily detected by the switch 400. The capacitance may also be a function of the dielectric constant and thickness of the shell of the spa and any intervening air, plastic, and/or glass between the object and the sensing target. By adjusting the oscillation frequency of the RC oscillator by changing the resistance of an integral potentiometer, the switch 400 may be calibrated to reliably detect the proximity of a nearby human hand.

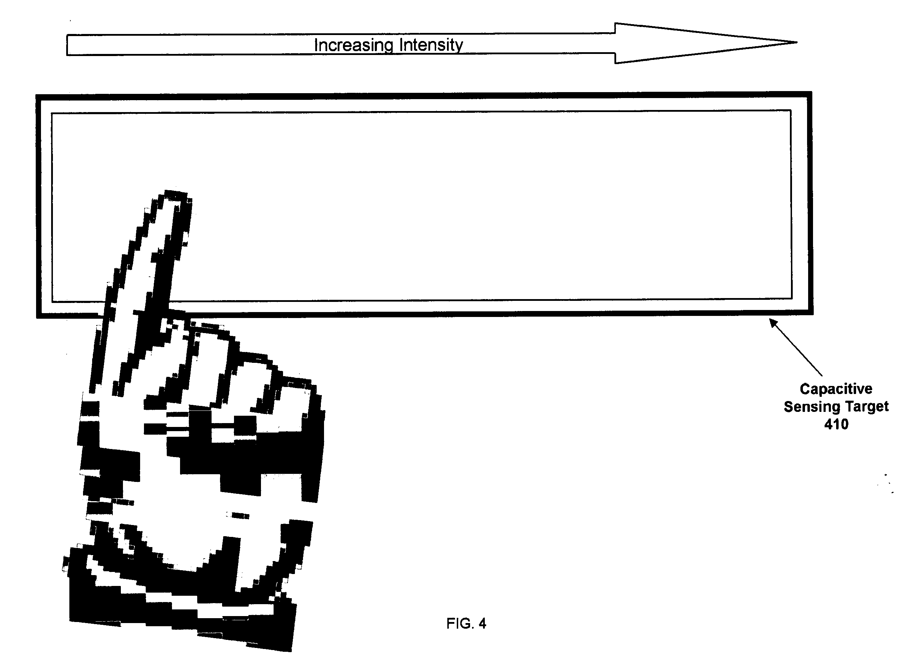

FIG. 4 shows a diagram of spa function control in which a user may control one or more spa functions in an "analog"-type manner. In FIG. 4, the capacitive sensing target 410 located on the spa has analog-type functionality in that the intensity of the spa function can vary depending on where the user contacts the sensing target 410. For example, one end location of the capacitive sensing target 410 may produce a spa function for a low-intensity signal, and an opposite end location of the capacitive sensing target may produce a spa function for a high-intensity signal. In this matter, a spa user can move their finger or hand in a direction across the capacitive sensing target 410 to increase or decrease the intensity of a spa function. For example, a user can control the functions of dimming a light in a spa or increasing a volume of a speaker for a spa sound system. The user can use the capacitive sensing target 410 to vary the intensity of the spa function in a manner other than a binary-type "on/off" function, or a stepping function (e.g., stepping up or stepping down). The spa functions that can be varied in intensity by this capacitive sensing technique are not limited to lighting, volume control, or water flow control, but may include other spa functions, such as controlling water temperature.

The illustrations depicted in FIGS. 1-4 may be described differently than as depicted and/or stated. The illustrations shown herein are merely exemplary of the implementations of the techniques. In one example, another type of oscillator may be used in Fig. 3. For instance, an inductor-capacitor (LC) oscillator may be used instead of a RC oscillator. In another implementation, the sensor may be located in a "footwell" of the spa, in which the user can place their foot in the footwell to activate or deactivate spa functions. Other implementations may be within the scope of the following claims.

## Claims

1. A spa control system comprising:
a capacitive sensor configured to receive input from a spa user, wherein the capacitive sensor is operable to sense a change in capacitance due to an object being in proximity with the capacitive sensor; and
a control unit coupled with the capacitive sensor to control at least one function.

2. The system in accordance with claim 1, wherein at least one spa function comprises a water flow control.

3. The system in accordance with claim 1, wherein the capacitive sensor comprises a sensing target, wherein the sensing target comprises an area of a spa shell to be contacted to change the capacitance.

4. The system in accordance with claim 3, wherein the sensing target is demarcated on the area of the spa shell with any one of a decorative design, a label, a molding, a pattern or a texture.

5. The system in accordance with claim 3, wherein the capacitive sensor is operable at a location below a water level of water in the spa.

6. The system in accordance with claim 3, wherein the capacitive sensor is operable at a location at or above a water level of water in the spa.

7. The system in accordance with claim 1, wherein the object in proximity of the capacitor sensor is detected across a non-conductive gap.

8. The system in accordance with claim 7, wherein the gap comprises any one of a gap comprising air, a gap comprising plastic, or a gap comprising glass.

9. The system in accordance with claim 1, wherein the capacitive sensor is located at a seating area in the spa.

10. The system in accordance with claim 1, wherein the capacitive sensor is located in a footwell area of the spa.

11. The system in accordance with claim 1, wherein the at least one spa function comprises any of a volume of a spa speaker, a lighting intensity of a spa light, and a water temperature.

12. The system in accordance with claim 1, wherein the capacitive sensor is configured to provide user control of an intensity of the at least one function.

13. The system in accordance with claim 1, wherein the capacitive sensor is configured to provide binary function control, stepping function control, and analog function control of the at least one function.

14. A method to control one or more functions of a spa, the method comprising:
receiving user input using capacitive sensing to adjust at least one spa function, wherein the capacitive sensing comprises:
detecting when an object is in proximity of an oscillator, wherein the oscillator is operable to vibrate when an object is in proximity of the oscillator, and wherein a capacitance of the oscillator is a function of the proximity of the object with the oscillator;
detecting a vibration of the oscillator when the object is in proximity of the oscillator;
changing a status of a control device in response to detecting the vibration; and adjusting the at least one spa function based on the changing of the status of the control device.

15. The method in accordance with claim 14, wherein at least one spa function comprises controlling water flow.

16. The method in accordance with claim 14, wherein a spa control unit is configured to adjust the at least one spa function in response to the changing status of the control device.

17. The method in accordance with claim 14, wherein the input is received at a sitting area of the spa.

18. The method in accordance with claim 14, wherein the adjusting comprises adjusting a water flow.

19. An apparatus to control one or more spa operations, the apparatus comprising electrical components operable to:
detect an input from a user by sensing a change in capacitance in response to an object being in proximity of a capacitive sensor;
convert the detected input into a signal to change a state of a control device, wherein the control device is coupled to one or more spa controls; and
adjusting the one or more spa controls in response to the change in state of the control device.

20. The apparatus in accordance with claim 19, wherein at least one spa control comprises a water flow control unit.

21. The apparatus in accordance with claim 19, where the signal detector comprises a sensing target located in proximity to a seating area of the spa.

22. The apparatus in accordance with claim 19, wherein the input detected comprises a capacitance between a sensing target and the object.
